Europäisches Patentamt

European Patent Office

Office européen des brevets

(11) Publication number: 0 384 586
A2

# (12) EUROPEAN PATENT APPLICATION

(21) Application number: 90300934.8

(22) Date of filing: 30.01.90

(51) Int. Cl.⁵: H01L 23/02, H01L 23/50

(30) Priority: 22.02.89 US 313769

(43) Date of publication of application:
29.08.90 Bulletin 90/35

(84) Designated Contracting States:
DE FR GB IT NL

(71) Applicant: TEXAS INSTRUMENTS
INCORPORATED
13500 North Central Expressway
Dallas Texas 75265(US)

(72) Inventor: McLelland, Robert N.
4427 Rosser Square
Dallas, Texas 75244(US)

(74) Representative: Abbott, David John et al
Abel & Imray Northumberland House 303-306
High Holborn
London, WC1V 7LH(GB)

(54) High reliability plastic package for integrated circuits.

(57) A high reliability plastic package (30) which in-
cludes palladium plated and solder dipped leads (18)
for electrical connection to electrical components as
well as a support (10) for electrically contacting a
seminconductor integrated circuit device is dis-
closed. A method for manufacturing such package is
also disclosed.

FIG 2

## HIGH RELIABILITY PLASTIC PACKAGE FOR INTEGRATED CIRCUITS

### BACKGROUND OF THE INVENTION

#### 1. Field of the Invention

This invention relates to improved packages for integrated circuit devices and methods for manufacturing improved packages.

#### 2. Description of Related art

Typical integrated circuit packages are constructed with lead frames made of copper alloy base metals. These lead frames are plated with silver at the terminations of the inner leads to facilitate gold wire bonding from the inner leads to the integrated circuit. Following wire bonding, the lead frame and circuit assemblies are typically encapsulated with an epoxy based plastic mold compound to provide mechanical and corrosion protection for the delicate circuit.

The adhesive bond between the encapsulation plastic and the inner lead of the lead frame is of low strength and frequently subject to delamination or deterioration. Delamination of the bond between the mold compound and the inner lead frame member provides a potential path for the ingress of moisture and other contaminants that can reach the integrated circuit surface and cause corrosion. Delamination of the lead frame can cause other problems with the mechanical integrity of the package during thermal shock or temperature cycling cracking. These types of problems are becoming more frequent as chip dimensions become larger and package sizes become smaller. One specific type of problem, called "popcorn cracking" causes cracks to form after the chip pad becomes delaminated from the mold compound during surface mount solder reflow.

The use of a ceramic package body tends to greatly increase the package resistance to moisture ingression and cracking, however ceramic packages represent a major cost that is prohibitive for most commercial applications.

Another problem with the current assembly technology for integrated circuit packages relates to the method of covering the outer device leads with solder. A solder coating is required on the other lead to facilitate soldering to the circuit board in final assembly. During package manufacturing, the base metal of the lead frame becomes oxidized. The soldering process requires the use of corrosive fluxes for dipping or precleaners for solder plating. The presence of residues of these chemicals makes the finished device particularly sensitive to corrosion.

The use of a flood plated lead frame with a thin coating of a precious metal is known. Packages made with these lead frames present a solderable lead surface without the necessity of a separate solder dipping or plating step, and would hence be less susceptible to corrosion because of the lack of processing chemicals. Such an assembly technique also offers a potential for cost reduction due to the elimination of the solder coating step. This approach, however has met with considerable resistance from the device end users because of reluctance to change to the new outer lead finish and also to a reduction in the measured solderability of such lead finishes.

### SUMMARY OF THE INVENTION

In accordance with the present invention, a high reliability plastic package is disclosed, that includes palladium plated and solder dipped leads for electrical connection to electrical components and support for electrically contacting a semiconductor integrated circuit.

The present invention provides on the internal leads a palladium surface which is excellent for thermosonic bonding of gold wire to the lead. Such gold wire bonds are equal or better in strength and reliability to prior art bonds made to silver spot inner leads. The solder coated external leads of the present invention offer an excellent solderable surface that device end users will have little difficulty accepting.

In addition, the initial palladium surface of the external leads allows for the use of less corrosive chemicals for either the plating activation step or solder dip fluxing. This is because the palladium remains relatively tarnish free and hence the final solder finish is easier to apply by either plating or dipping.

The primary advantage of the present invention lies in he high adhesive strength associated with palladium to mold compound bonds. This excellent strength is the result of the high surface free energy of palladium. Such surfaces with high free energies present many potential bonding sites to plastic used for molding the package. Direct pull tests of adhesion indicate that palladium plating increases lead frame to mold compound adhesion by approximately 100%. Accelerated reliability testing of the present invention indicates dramatic increases in the expected device life over previous packages. In addition, acoustic microscopy tests have demonstrated that the present invention packages are much less subject to delamination during thermal shock than are prior art packages. These results are supported by additional tests of dye ingression into packages which show the present invention to be superior over prior art packages.

Another advantage of the present invention is that it will be compatible with the industry wide push to replace the gold bonding wires to copper bonding wires. Tests have shown that copper wire bonds to palladium plated lead frames are simpler to form than similar bonds to either bare or silver plated lead frames.

From the foregoing discussion, it is appreciated that the high reliability integrated circuit package of the invention represents a significant increase in the resistance to temperature cycle cracking and moisture related corrosion problems.

The package is also cost effective. The palladium plated lead frame member is manufactured such that it represents only a minimum cost premium over standard silver spot lead frames. This is accomplished through the use of a less than 10 microinch palladium plate. What cost is added can typically be compensated for by the simplification of the solder plate or dip steps. Use of the palladium external leads has been shown to increase the yields during the solder coating steps and hence reduce the overall cost of the package manufacturing.

These and other advantages and objects of the invention can be more readily understood from a reading of the specification in conjunction with the drawings.

## BRIEF DESCRIPTION OF THE DRAWING

Figure 1 is a plan view of a lead frame with attached integrated circuit. As shown, the lead frame is a section of a strip of a plurality of lead frames and shows only three leads.

Figure 2 is an end, sectional view of an integrated circuit device in accordance with the invention.

## DESCRIPTION OF THE PREFERRED EMBODIMENTS

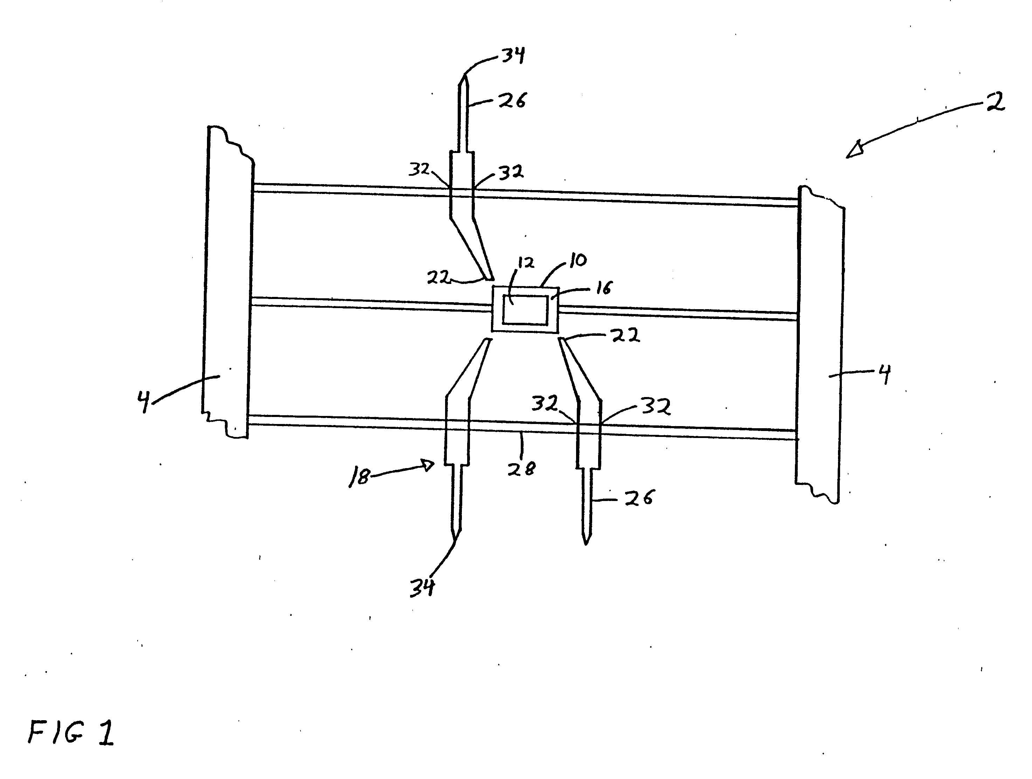

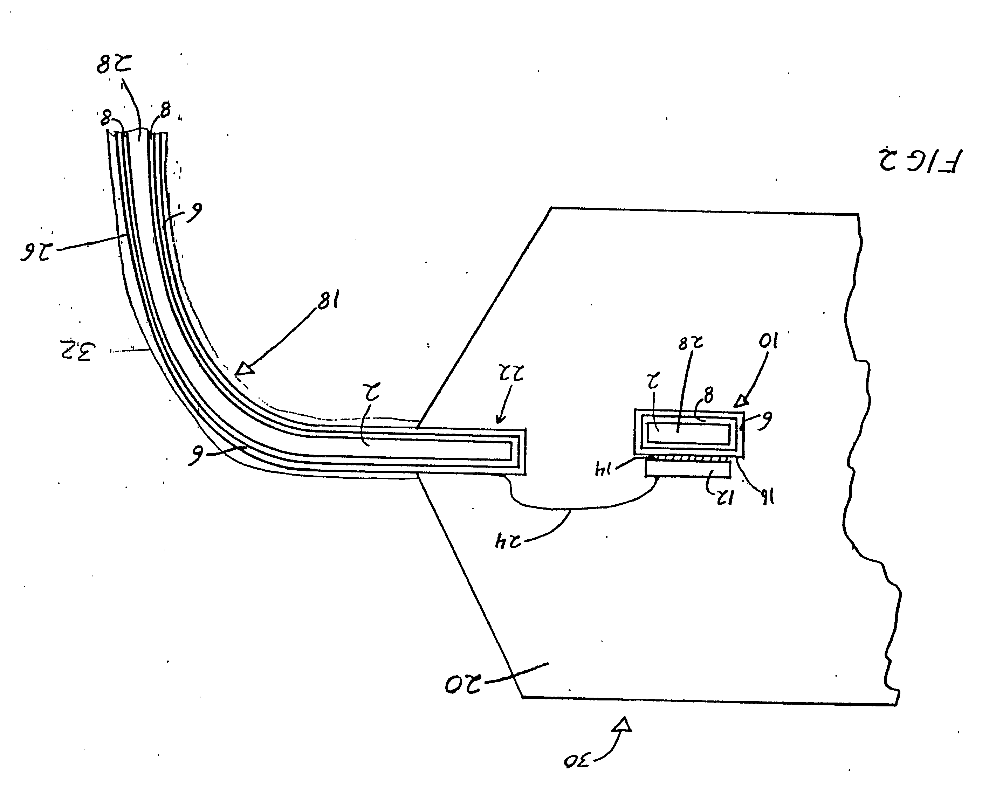

Turning to figures 1 and 2, a lead frame 2 or a plurality of such lead frames connected to each other by connecting strips 4 are prepared for flood plating first with nickel 8 and then with palladium 6. Nickel is used to prepare the base metal for the layer of plated palladium. The palladium layer 6 and the nickel layer 8 are each deposited in a layer which is substantially uniform in thickness. Thus, no discontinuities in lead frame thickness arise from the plating process.

Another embodiment of the invention is to replace the palladium layer 6 with a plated layer 6 of palladium-nickel alloy consisting of 80 nickel. The palladium plate covers all the surfaces of the lead frame prior to the usual step of trimming excess metal from the lead frame.

Refer now to Figure 1. As is standard with prior art devices, the dam bars 28 are trimmed away after the packaging medium 20 has been applied. Also, adjoining lead frames in a strip of a plurality of lead frames are trimmed to separate them one from the other. After the trimming process is complete, however, the remaining members of the lead frame still have substantially all of their surfaces covered with a layer of palladium. The areas of exposed base metal 28 will be, chiefly, the small areas 32 on each external lead 26 where the dam bars 28 have been cut away, and the external lead tips 34 which are cut to separate them from the strip of lead frames. It will be appreciated that although it is most economical and the preferred method is to plate a plurality of lead frames 2 connected by strips 4, the invention embraces palladium plating of lead frames singly or plurally no matter how connected. It will also be appreciated that although palladium flood plating is the preferred method, palladium spot plating or any other plating method is also encompassed by the invention. Flood plating is a term well known in the art and refers to plating an entire object by immersion. Spot plating is also a term of art and refers to plating an object in circumscribed areas or spots, as by masking the portions of the object not to be plated.

As shown in Figure 1, the lead frame 2 is comprised of several members, such as the leads 18 and the semiconductor support member 10. Adjacent leads are mechanically connected by dam bars 28. After the packaging medium 20 is in place surrounding all but the external leads 26, the dam bars are removed.

Turning now to Figure 2, a palladium plated semiconductor support member 10 is shown with a semiconductor integrated circuit 12 attached by an adhesive 14 to the upper surface 16 of the semiconductor support member. The adhesive 14 preferably is electrically conductive to form a good electrical connection between the base of the integrated circuit 12 and the palladium plated upper surface 16 of support member 10.

Continuing with Figure 2, lead 18 is supported mechanically by the packaging medium 20, which may be a material such as plastic or ceramic. The packaging medium surrounds, protects, and mechanically supports the leads 18, semiconductor support member 10, and integrated circuit 12. The lead portion nearest the semiconductor support member 10 is referred to as the lead end 22, and is electrically connected to the integrated circuit 12 via a wire 24 which, typically, is made of gold. The gold wire is bonded directly to the palladium plated upper surface of lead end 22, thermosonically or by another suitable technique. Thermosonic bonding is a well known technique and, essentially, consists of a combination of heat and sonic energy delivered via a wand to the combination of metals to be bonded.

As seen in Figure 2, palladium plated external lead 26 protrudes from the packaging medium 20. External lead is solder dipped to form a layer of solder 32 using methods well known in the art. This prepares the external leads 26 to be electrically connected to other electrical or electronic parts, such as by soldering or mechanically as with clips or sockets. Typically, the external leads of the integrated circuit device 30 are connected to components such as resistors, capacitors, other integrated circuit devices, or equipment such as meters and oscilloscopes for testing purposes.

The base metal for either of the illustrated embodiments may be chosen from such well known alloys as Alloy 42 which, roughly, is 42% nickel, 58% iron, and small amounts of several other elements; any one of several copper alloys used for lead frames; 400 stainless steel; and copper/stainless steel/copper clad metals. These alloys are well known in the art and are commonly used for lead frame construction.

Although the invention has been described with a certain degree of specificity, it is obvious to one skilled in the art that variations can be made to the disclosed embodiments without varying from the scope of the invention, which scope is set forth by the appended claims.

## Claims

1. A high reliability plastic package comprising:
(a) palladium plated and solder coated leads for electrical connection to electrical components; and
(b) support for electrically contacting a semiconductor integrated circuit.

2. The package according to claim 1 wherein the solder coated leads are fabricated by solder dipping.

3. The package according to claim 1 wherein the solder coated leads are fabricated by solder plating.

4. The package according to claim 1 wherein the leads include solder coated palladium plated external leads for electrical connection electronic parts.

5. The package according to claim 1 wherein the leads are plated with a palladium alloy having a high surface free energy.

6. The package according to claim 1 wherein the leads are plated with a palladium and nickel alloy which is 80% palladium and 20% nickel.

7. The package according to claim 1 wherein the leads include palladium plated leads for electrical connection to the semiconductor integrated circuit.

8. The package according to claim 1 wherein, the semiconductor support is palladium plated.

9. The package according to claim 1 wherein the leads include a plurality of wires for electrically connecting the plurality of leads to a plurality of points on the semiconductor integrated circuit.

10. An integrated circuit device comprising:
(a) palladium plated and solder coated leads for electrical connection to electrical components; and
(b) a semiconductor integrated circuit;
(c) a support for electrically containing a semiconductor integrated circuit; and
(d )a plurality of wires for electrically connecting the plurality of palladium plated leads to a plurality of points on the semiconductor integrated circuit means.

11. The integrated circuit device of claim 10 wherein the plurality of wires are bonded to the plurality of palladium plated leads.

12. The integrated circuit device according to claim 10 further comprising electrically conductive adhesive for electrically and mechanically connecting the semiconductor integrated circuit to the semiconductor support.

13. The integrated circuit device according to claim 10 further comprising a packaging medium for supporting and protecting the lead frame and semiconductor integrated circuit.

14. The integrated circuit device according to claim 10 wherein the plurality of wires are a plurality of gold wires.

15. The integrated circuit device according to claim 10 wherein the packaging medium is plastic.

16. The integrated circuit device according to claim 10 wherein the palladium plated lead and the palladium plated semiconductor support include nickel plated layer for preparing the lead and semiconductor support for palladium plating.

17. The integrated circuit device according to claim 10 wherein the palladium plated leads are palladium-nickel alloy plated leads and the palladium plated semiconductor support means is a palladiuim-nickel alloy support.

18. The integrated circuit device according to claim 10 wherein the solder coated leads are fabricated by solder dipping.

19. The integrated circuit device according to claim 10 wherein the solder coated leads are fabricated by solder plating.

20. A method for fabricating a high reliabilty plastic package for an integrated circuit device, comprising the steps of;

(a) palladium plating a lead frame;

(b) placing an integrated circuit device on said lead frame;

(c) electrically connecting said integrated circuit device to said lead frame;

(d) forming a plastic package around around the integrated circuit device and selected portions of said lead frame thereby forming exposed leads; and

(e) coating selected portions of the exposed leads with a solder for electrical connection to electrical components.

21. The method according to claim 20 wherein the coating step is solder dipping.

22. The method according to claim 20 wherein the coating step is solder plating.

FIG 1

FIG 2